# EUROPEAN PATENT APPLICATION

(11) **EP 4 818 735 A1**
(43) Date of publication of application: **07.10.2026**
(21) Application number: 25167268.9
(22) Date of filing: 31.03.2025
(51) Int. Cl.: G01R 33/58

(54) **AUTOMATED POSITIONING OF QUANTITATIVE MAGNETIC RESONANCE IMAGING PHANTOMS**

(71) Applicant: Koninklijke Philips N.V., 5656 AE Eindhoven (NL)
(72) Inventor: LEUSSLER, Christoph Günther, Eindhoven (NL); DONEVA, Mariya Ivanova, Eindhoven (NL)
(74) Representative: Philips Intellectual Property & Standards

(57) **Abstract**

Disclosed herein is a medical system (100, 300, 500, 700, 900, 900') comprising a phantom positioning system. The phantom positioning system comprises: a phantom mount (102) configured for receiving a quantitative MRI phantom (108) and an automated actuator (104) configured to reposition the phantom mount in response receiving movement commands. The movement commands are preferably embedded in quantitative MRI calibration pulse sequence commands (948).

## Description

### FIELD OF THE INVENTION

The invention relates to magnetic resonance imaging, in particular to phantoms for calibrating quantitative magnetic resonance imaging.

### BACKGROUND OF THE INVENTON

Quantitative magnetic resonance imaging (qMRI) is a collection of magnetic resonance imaging techniques that extend beyond conventional magnetic resonance imaging by providing objective, numerical assessments of spatially dependent tissue properties. In this context, quantitative MRI may use specialized pulse sequences to measure intrinsic parameters-such as T1 and T2 relaxation times and proton density-thereby enabling the reproducible quantification of biological tissues and facilitating early detection and precise monitoring of pathological conditions.

Quantitative magnetic resonance imaging encompasses a range of specialized techniques each with its own methodology. T1 and T2 mapping techniques, for example, offer quantifiable assessments of relaxation times that serve as vital indicators of tissue composition and pathology, while diffusion-weighted imaging (DWI) and diffusion tensor imaging (DTI) provide detailed insights into the microstructural properties of tissues through the evaluation of water molecule movement. Quantitative susceptibility mapping (QSM) is employed to measure magnetic susceptibility variations. MR elastography quantify tissue stiffness, thereby extending the diagnostic utility of quantitative MRI into the realm of biomechanical assessment. Another example is magnetic resonance fingerprinting. In magnetic resonance fingerprinting, a pulse sequence uses a sequence of pulse sequence parameters to excite material or tissue specific magnetic resonance signal patterns. The signal patterns can then be compared to a dictionary of signal patterns to determine not only the tissue types within a voxel but also other spatially dependent values such as relaxation times.

### SUMMARY OF THE INVENTION

The invention provides for a medical system, a method of operating a medical system, and a computer program in the independent claims. Embodiments are given in the dependent claims.

In one aspect a medical system comprising a phantom positioning system is disclosed. The phantom positioning system comprises a phantom mount configured for receiving a quantitative MRI phantom. The phantom positioning system further comprises an automated actuator configured to reposition the phantom mount in response to receiving movement commands. The movement commands are preferably embedded in quantitative MRI calibration pulse sequence commands.

In another aspect a method of operating a medical system is disclosed. The medical system comprises a phantom positioning system and a magnetic resonance imaging system. The phantom positioning system comprises a phantom mount configured for receiving a quantitative MRI phantom. The phantom positioning system further comprises an automated actuator configured to reposition the phantom mount in response to receiving movement commands. The movement commands are preferably embedded in quantitative MRI calibration pulse sequence commands. The method comprises acquiring calibration k-space data by controlling the magnetic resonance imaging system with the quantitative MRI calibration pulse sequence commands. The method further comprises repositioning the phantom mount in between acquisitions of calibration k-space data by sending the movement commands to the automated actuator. The method further comprises generating spatially dependent quantitative MRI calibration using the repeatedly acquired calibration k-space data and the movement commands.

In another aspect a computer program is disclosed. The computer program comprises a computer-readable storage medium having machine-executable instructions embodied therewith. The machine-executable instructions are configured to implement an example of the method.

### BRIEF DESCRIPTION OF THE DRAWINGS

In the following preferred embodiments of the invention will be described, by way of example only, and with reference to the drawings in which:
- Fig. 1: illustrates an example of a medical system.
- Fig. 2: shows a flow chart which illustrates a method of using the medical system of Fig. 1.
- Fig. 3: illustrates an example of a medical system.
- Fig. 4: shows a flow chart which illustrates a method of using the medical system of Fig. 1.
- Fig. 5: illustrates an example of a medical system.
- Fig. 6: shows a flow chart which illustrates a method of using the medical system of Fig. 1.
- Fig. 7: illustrates an example of a medical system.
- Fig. 8: shows a flow chart which illustrates a method of using the medical system of Fig. 1.
- Fig. 9: illustrates a further example of a medical system.
- Fig. 10: illustrates a further view of the medical system illustrated in fig. 9.
- Fig. 11: shows a flow chart which illustrates a method of using the medical system of Figs. 9 and 10.
- Fig. 12: illustrates a view of a cloud based medical system.

### DETAILED DESCRIPTION OF EMBODIMENTS

Like numbered elements in these figures are either equivalent elements or perform the same function. Elements which have been discussed previously will not necessarily be discussed in later figures if the function is equivalent.

In one aspect a medical system comprising a phantom positioning system is disclosed. The phantom positioning system comprises a phantom mount configured for receiving a quantitative MRI phantom. The phantom positioning system further comprises an automated actuator configured to reposition the phantom mount in response to receiving movement commands. The movement commands are preferably embedded in quantitative MRI calibration pulse sequence commands. Quantitative MRI is a magnetic resonance imaging technique that used to generate quantitative data or maps about tissue. Various parameters such as the magnetic resonance signal with the T1 and T2 relaxation times, proton density and diffusion coefficients can be used to infer such things as particular tissue types or quantities about tissue regions. When performing quantitative MRI it may be beneficial to calibrate the measurements. The quantitative MRI phantom is a phantom which enables the calibration of a quantitative MRI imaging protocol. The automated actuator is used to move or reposition the phantom mount and thereby the quantitative MRI phantom in different locations so that a particular sample or samples of the quantitative MRI phantom can be moved and have data acquired at different locations.

This may for example be useful in that some quantities in quantitative MRI imaging may be dependent upon the magnet field inhomogeneities. By moving the quantitative MRI phantom to different locations it may be possible to have a better calibration of the quantitative MRI protocol. Various means may be used for implementing the automated actuator in different examples. In one case compressed air could be used to rotate a gear system attached to a propeller system, a fixed linkage could be used to rotate a geared system, or even a pulse string could be used to actuate the automated actuator and have it moved to different positions. Various controls and actuators or motors may be used to automate this process and have it respond to movement commands. In the example that the movement commands are preferably embedded in the quantitative MRI pulse sequence commands this may be beneficial because it enables the pulse sequence to be provided with the movements for the automated actuator also.

The phantom positioning system may in general be beneficial because it is difficult to move the quantitative MRI phantom controllably in different locations within the bore or magnet of the magnetic resonance imaging system. The automated actuator may for example enable better and more detailed calibrations of the quantitative MRI phantom within a magnetic resonance imaging system.

Quantitative MRI (QMRI) refers to the measurement of physical properties like relaxation times, diffusivity, or flow velocity using MRI. Due to its nature, it promises more consistent and reproducible scans as well as tissue characterization compared to conventional contrast weighted MRI images. One way of ensuring that the desired accuracy and reproducibility is achieved and determine relevant thresholds for normal values of quantitative parameters, one may characterize the quantitative MRI scan for different systems, software releases and imaging conditions. Such characterization can be done using quantitative MRI phantoms. With such assessment in place, it may be relevant to establish a quality assurance process both for the vendors and for the customers using quantitative MRI.

In some examples, such QA procedure may be both automatic and reproducible. However, such automated and reproducible approach is currently not available and may require many manual steps prone to errors in the experimental setup and the analysis. This leads to both difficulty in implementing QA procedures for quantitative MRI and the reduced reliability of the assessment.

In addition, the phantom vendors currently provide a limited guarantee for the accuracy of the provided reference values (18-36 months) adding another factor that may be tracked to ensure the accuracy of the QA procedure.

Examples may provide for an automatic control system for the positioning of the quantitative MRI phantoms required to characterize the quantitative MRI scan for different systems, hardware settings, software releases and imaging conditions using an actuator platform system, which is fully controlled by MR scanner SW. This may help to overcome one or more of the following problems in calibrating quantitative magnetic resonance imaging:
- manual moving of the phantom at a set of predefined off-center positions
- accuracy of the position is insufficient
- reproducibility is not in the defined specs
- experienced user, operator required
- time consuming procedure

In another example the automated actuator is configured to position the phantom mount with respect to coordinates within a bore of a magnetic resonance imaging magnet. Very typically a magnet for a magnetic resonance imaging system will have an x, y, z coordinate with the z running along the central region the and aligned with the magnetic field lines. Having the automated actuator move in relative or actual coordinates with respect to the magnetic resonance imaging magnet may provide for a better calibration. When measurements are made in a magnetic resonance imaging system their location is known with respect to its own coordinates. Having the phantom mount also be able to move in absolute or relative coordinates that match these may enable better positioning during the calibration.

In another example the medical system further comprises the quantitative MRI phantom attached to the phantom mount. The quantitative MRI phantom comprises at least one quantitative MRI calibration sample. The automated actuator is configured to move the at least one quantitative MRI calibration sample to multiple locations in response to receiving the movement commands. As was mentioned above, this may enable having the quantitative MRI calibration performed at more than one spatial location.

In another example the quantitative MRI phantom comprises at least one sample-specific sensor configured for measuring sample-specific data. The quantitative MRI phantom comprises a data transmission system for transmitting the sample-specific data. The sample-specific data preferably comprises any one of the following: a sample temperature, a sample conductivity, a sample pH value and combinations thereof. The data transmission system is preferably a radio-frequency communication system or preferably a fiber optic communication system. The actual properties of the quantitative MRI phantom may change over time or may change with atmosphere conditions such as the temperature. Having the sample-specific sensors and the sample-specific data enables the measurement of the sample-specific data and using this directly in the calibration of the quantitative MRI protocol. This may provide for a more accurate determination of a calibration using the quantitative MRI phantom.

In another example, the quantitative MRI phantom comprises an identification element configured to provide any one of the following: identification of a quantitative MRI phantom type, an expiration date of the quantitative MRI phantom, a serial number linked to a data source, such as a database, descriptive of the quantitative MRI phantom, and combinations thereof. This data may be provided in different ways. For example, in some instances there may be a QR code or other optically readable label which provides this information directly. In other examples there may be a serial number or pointer which is used to provide a data source which may provide this information. In yet other examples there may for example be an RFID tag or other tag which may store this data locally at the quantitative MRI phantom and provide it directly. This may be beneficial because it may for example be useful in ensuring that a quantitative MRI phantom that has gone off due to being too old is not used. It may also for example be useful in ensuring that the calibration matches the type of quantitative MRI phantom that was provided also.

In another example the quantitative MRI phantom further comprises radio-frequency coils for measuring k-space data descriptive of the at least one quantitative MRI calibration sample. The radio-frequency coils are preferably surface coils attached to an external surface of the quantitative MRI phantom. The quantitative MRI phantom comprises a data transmission system for transmitting the k-space data. The transmission system is preferably a radio-frequency communication system or preferably a fiber optic communication system. For example, small surface coils may be attached to the outer surface of the quantitative MRI phantom and provide known radio-frequency coils for measuring the k-space data. This may for example be very useful as it does not require the installation of additional radio-frequency coils for measuring the calibration k-space data. Also, as the radio-frequency coils are provided with the MRI phantom, the results in the calibration may be more consistent than using other magnetic resonance imaging coils for performing the calibration.

In another example the phantom positioning system is integrated into a magnetic resonance imaging coil. The magnetic resonance imaging coil is preferably a head coil or a breast coil. Having the phantom positioning system integrated into the magnetic resonance imaging coil may provide for a convenient means of consistently placing the quantitative MRI phantom in the same locations with respect to the magnetic resonance imaging coil. This may facilitate the consistent calibration of the quantitative MRI protocol.

In another example the phantom positioning system is integrated into a magnetic resonance imaging subject support. For example, magnetic resonance imaging systems may have subject supports which are used to insert the subject into the bore of a cylindrical magnet. By having the phantom positioning system integrated into the magnetic resonance imaging subject support the quantitative MRI phantom may be conveniently placed in the subject support and then automatically inserted into the magnetic resonance imaging system. This may enable consistently placing the quantitative MRI phantom in the same position in different calibrations.

In another example the medical system further comprises a vibration cancellation system. The vibration cancellation system comprises a piezoelectric actuator configured for moving the phantom mount to counteract vibrations of the quantitative MRI phantom. The technology for implementing this may be similar to that used for correcting noises in aircraft or even noises in magnetic resonance imaging systems. Often times the various phantoms in the quantitative MRI phantom are formed from liquid solutions. The vibrations, particularly due to gradient noise in the magnetic resonance imaging system, may cause the fluid within a particular phantom to slosh around or to circulate. This circulation can for example cause spins to move once they have been encoded during a pulse sequence. This may lead to a degradation in the quality of the calibration or introduce artifacts into the calibration. The vibration cancellation system may help to ensure that the individual phantoms in the quantitative MRI phantom are more stable and have less fluid circulation within them.

In another example the piezoelectric actuator is at least partially configured to be controlled to counteract the vibrations of the quantitative MRI phantom determined using any one of the following: an acoustic sensor, an optical motion sensor, a microwave sensor, and combinations thereof. An acoustic sensor could be placed in the vicinity of the quantitative MRI phantom and be used to determine the amount of vibrations due to acoustic noise. This may be very similar to the technology used for noise cancellation in headphones. In addition to measuring acoustic noise, the actual motion of the quantitative MRI phantom can be used by having an optical motion sensor which could for example look at tick marks or optical fiducial marks on the quantitative MRI phantom and measure its motion optically. A microwave sensor could also be installed in the bore of the magnet and measure the physical movement of the quantitative MRI phantom also. In all of these cases this could be used as part of a control system to counteract the vibrations adaptively.

In another example the piezoelectric actuator is at least partially configured to be controlled to counteract the vibrations of the quantitative MRI phantom determined by a transfer function that receives gradient coil commands (commands for controlling the power supply of the gradient coils) as input and predicts the noise generated by the gradient coils. The gradient coil commands, for example, being specified in the MRI calibration pulse sequence commands. For a particular magnetic resonance imaging system and magnet, the gradient coils may make a predictable amount of noise or cause a particular amount of acoustic vibrations due to use of the gradient coils. This could be calibrated and used to provide the transfer function. Once this transfer function is known one could then input the pulse sequence commands or controls for the gradient coils and receive an accurate estimate of the mechanical vibrations caused by the gradient coils. This may be an effective means of predicting and then counteracting the vibrations of the quantitative MRI phantom. This may lead to a higher quality calibration.

In another example the medical system further comprises a magnetic resonance imaging system. The magnetic resonance imaging system comprises a memory storing machine-executable instructions and the quantitative MRI calibration pulse sequence commands. The magnetic resonance imaging system further comprises a computational system. Execution of the machine-executable instructions causes the computational system to repeatedly acquire calibration k-space data by controlling the magnetic resonance imaging system with the quantitative MRI calibration pulse sequence commands. Execution of the machine-executable instructions further causes the computational system to repeatedly reposition the phantom mount in between acquisitions of the calibration of k-space data by sending the movement commands to the automated actuator. Execution of the machine-executable instructions further causes the computational system to repeatedly generate a spatially dependent quantitative MRI calibration using the repeatedly acquired calibration k-space data and the movement commands. In this example the pulse sequence commands are used to acquire the calibration k-space data and also control the movement of the automated actuator. In this way this example is able to generate a spatially dependent quantitative MRI calibration automatically. It may be extremely difficult or nearly impossible to move the quantitative MRI phantom manually during an actual calibration. One would need to have access to the phantom in the bore of the magnet and then move it precisely to different locations. These examples provide an automated means of doing this in a consistent and extremely accurate fashion.

The magnetic resonance imaging system could also be a hybrid system that combines a therapeutic system with the magnetic resonance imaging system. For example, the medical system could additionally comprise a LINAC, RF ablation system, a gamma knife, a laser system, or a catheter which incorporates RF or laser ablation. The quantitative magnetic resonance imaging could then be used to assess the effectiveness and/or quality of the therapeutic system.

In another example the quantitative MRI calibration pulse sequence commands are configured according to a predetermined quantitative MRI protocol. The memory further stores quantitative MRI pulse sequence commands configured to acquire subject k-space data according to the predetermined quantitative MRI protocol. Execution of the machine-executable instructions further causes the computational system to acquire subject k-space data by controlling the magnetic resonance imaging system with the quantitative MRI pulse sequence commands. Execution of the machine-executable instructions further causes the computational system to reconstruct a quantitative magnetic resonance imaging image using the subject k-space data and the spatially dependent quantitative MRI calibration. This example may be beneficial because it may provide for a higher quality quantitative magnetic resonance image because the calibration was of higher quality and was also performed at spatially dependent locations.

In another example there is a method of operating the medical system that comprises the magnetic resonance imaging system. The method comprises acquiring calibration k-space data by controlling the magnetic resonance imaging system with the quantitative MRI calibration pulse sequence commands. The method further comprises repositioning the phantom mount in between acquisitions of the calibration k-space data by sending the movement commands to the automated actuator. The method further comprises generating a spatially dependent quantitative MRI calibration using the repeatedly acquired calibration k-space data and the movement commands. The advantages of this have been previously discussed.

In another example there is a computer program which comprises a computer-readable storage medium having machine-executable instructions embodied therewith. The computer program could for example be a computer program product and the computer-readable storage medium may for example be a non-transitory storage medium. The machine-executable instructions are configured to implement an example of the method. The advantages of this have also been previously discussed.

It may be beneficial to perform magnetic resonance imaging (MRI) in a standardized way by using specialized phantoms (a quantitative MRI phantom) that enable tests to be performed on imaging equipment. In general, quantitative MRI phantoms are devices designed to simulate the response and interactions of human tissues and organs with the imaging device, thus ensuring appropriate imaging quality in living subjects.

Phantom measurements allow, for example but are not limited to, the assessment of geometric distortion, resolution, slice profile, signal-to-noise ratio (SNR), image uniformity, proton-spin relaxation times, diffusion, perfusion, chemical exchange, fat fraction, magnetic susceptibility, patient safety (B1 uniformity) and proton density.

Examples may provide for a medical system that controls and interacts with the sequential and parallel workflow steps such as positioning of an actuator, fixation of the phantom, calibration of the setup and automatic generation of data to characterize the quantitative MRI scans.

Examples may provide one or more of the following features:
1. An actuator (automated actuator) and frame setup (phantom mount), which is positioned on the MRI table or integrated in a volume coil.
2. An actuator (automated actuator) and frame setup (phantom mount) which is modular and adaptable for different MRI tables
3. Actuator device (automated actuator) with integrated sensors for position and 3D positioning.
4. Control via a remote control system or over the internet. For example, using a Radiology Operations Command Center (ROCC).
5. Detection of defined range of motion and/or threshold using sensors
6. The proposed device can be configured to allow and compatible to be vendor independent.
7. The system may have an additional open interface to be compatible with other vendors.
8. The actuator can switch between automatic and manual mode for predefined positions

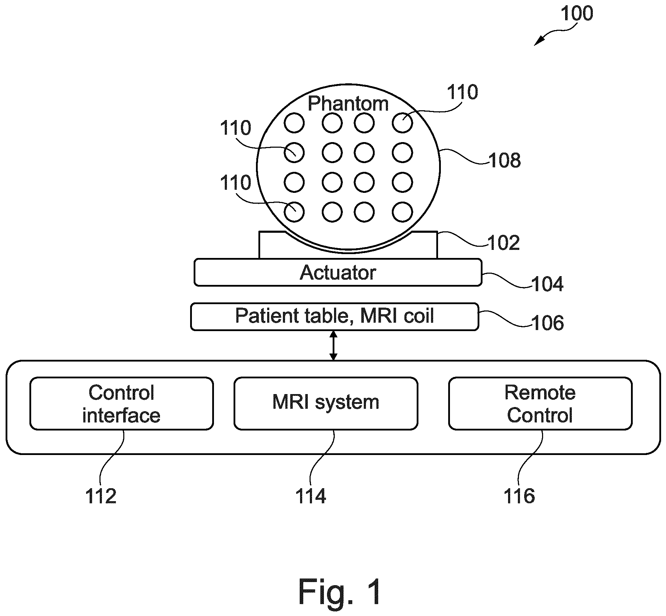

Fig. 1 illustrates an example of a medical system 100. The medical system 100 is shown as comprising phantom mount 102 which is configured for receiving a quantitative MRI phantom 108. The phantom mount 102 is connected to an automated actuator 104 which is able to move and position the quantitative MRI phantom 108 in different spatial locations. The quantitative MRI phantom 108 is shown as having a number of quantitative MRI calibration samples 110. These will typically be fluid samples which have known magnetic resonance imaging characteristics and can be used for calibrating quantitative magnetic resonance imaging protocols. The automated actuator 104 may be actuated in different ways such as with a mechanical linkage, a string, a stepper motor, or even air powered mechanism which may be used for actuating and moving the quantitative MRI phantom 108 within the bore of the magnet. The actuator 104 may be optionally mounted onto a support for the phantom mount 106. In this example it is shown as being either a patient table or being built into a magnetic resonance imaging coil. The phantom mount 102 and the automated actuator 104 could for example be built permanently into the patient table and/or the MRI coil. The medical system 100 is also shown as being optionally comprising a control interface 112 which may for example be a control interface for operating the actuator 104, it is shown as optionally comprising a magnetic resonance imaging scanner or system 114 and also a remote control 116. The remote control could for example be a ROCC control center and enable the remote calibration of the magnetic resonance imaging scanner 114.

As shown in Fig, 1 an actuator controls the position of a quantitative MRI phantom. The actuator is fixed on the patient table, via individual support, or located within or on MRI coil. A control interface is part of the actuator and defines the position of the individual setup via local sensing. The actuator for the phantom is driven either electromechanically, pneumatically or as a combination of both. Position and feedback is further controlled and defined by local sensors.

In one example, the automated actuator (104) is realized as a modular mechanical structure, where support (phantom mount 102) of the phantom (quantitative MRI phantom 108) and fixation to a base can be configured and are adaptable to different vendor specific supports 106 such as patient bed, coil holder or additional support.

In another example, a pneumatically actuated automated actuator 104 enables the translation of the phantom in different directions (up, down, right left, front, back). Individual air chambers may be configured with respect to particular hardware configurations.

Positioning of the automated actuator 104 with respect to MRI center of magnet may be realized by: optical camera (possibly integrated in the automated actuator 104) or optical markers and detection by external cameras, local recess in the patient bed or coil.

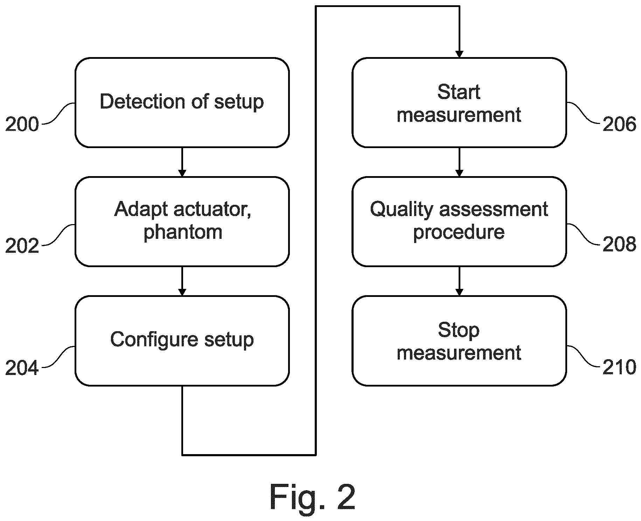

Due to different system conditions, SW release, Hardware/new gradient system/amplifier, modifications of phantom etc., a calibration procedure may be performed. An example of a software algorithm is presented in Fig. 2.

Fig. 2 shows an exemplary method of using the medical system 100 of Fig. 1 for performing a quantitative MRI calibration. Due to different system conditions, software releases as well as different hardware configurations of the magnetic resonance imaging system and also possibly modifications to the phantom 108, a calibration procedure may be performed which takes this into account. Fig. 2 is one such exemplary method. In 200 the detection of the setup which may be details of the magnetic resonance imaging system 114 as well as the quantitative MRI phantom 108 are detected. This could for example be in the form of a certificate, QR code, digital signal or manual input file. In 202 the system or an operator is interactively guided to adapt the position and actuator 104 and position the phantom 108. Integrated sensors in the automated actuator 104 may possibly be present and if so may give feedback during the positioning and adaptation process. In 204 the control interface 112 is configured based on coil and external parameters such as the phantom size, speed, calibration software, the particular quantitative MRI protocol as well as possibly the software configuration of the magnetic resonance imaging system 114.

In 206 the measurement is started and for example the subject support may be moved forward to the isocenter of the magnet and the measurement may begin. When the magnetic resonance imaging scanner detects an MRI safe environment, such as when the operator leaves the room, the RF door is closed, any electrical or mechanical safety is set up then the measurement may be started. The system may then collect the calibration data and the parameters for the imaging sequence are adapted. There may also be a quality assessment procedure 208 to determine the effectiveness and the quality of the calibration and in 210 the measurements are stopped and the data is used to generate a calibration for the magnetic resonance imaging system 114.

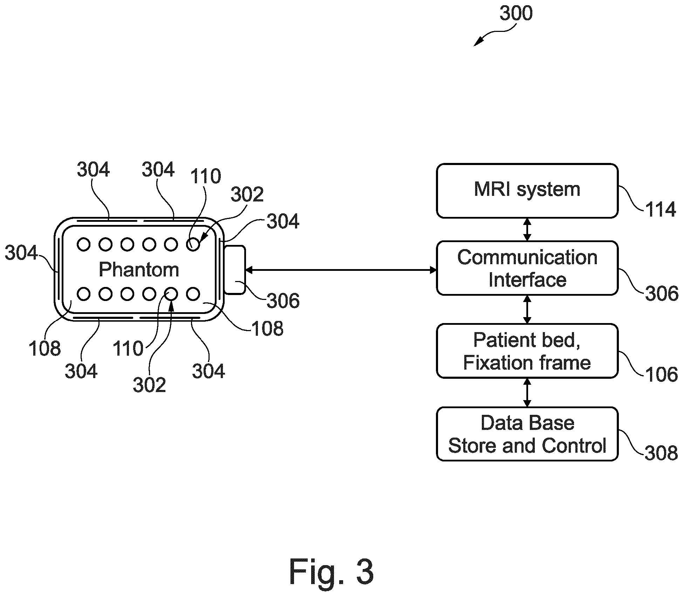

Fig. 3 illustrates a further example of the medical system 300. The features illustrated in Figs. 1 and 3 may be combined. In Fig. 3, the quantitative MRI phantom 108 shows several modifications. One or more of the quantitative MRI calibration samples 110 are shown as having sensors 302. The sensors 302 may for example measure such things as the temperature, pH, viscosity, optical transparency, conductivity, and other parameters which may affect the MRI measurements. Additionally, around the outer surface of the phantom 108 is a number of surface coils 304. The surface coils 304 are integrated in the phantom and may be used for measuring the calibration data. There is a communication interface 306 integrated in the phantom 108 and also into the magnetic resonance imaging system. This is able to communicate with the Magnetic resonance imaging system 114 and is integrated with the control of the patient bed and the fixation frame 106. There may also be a database 308 which is used to store the calibration data and also provide instructions for controlling the calibration.

In this example, the quantitative MRI phantoms 108 are equipped with sensors 302 to harvest the real time physical parameters with optimal signal performance using integrated RF coils 304 to improve the reliability of the assessment of quantitative MRI. Additionally, the RF coils 304 and sensors 302 may be fully integrated within the housing of the phantom 108. The interface or data transmission system 306 may integrated in the phantom 108 and controls the sensing devices and the communication to the Magnetic resonance imaging system 114.

In one example, the phantom 108 may comprise a quantitative MRI phantom with some additional mechanical structures, which contains the individual compartments required for calibration measurements. Each compartment for a calibration sample 110 may be monitored using sensors 302 to measure the physical parameters of the phantom substance (temperature, conductivity, pH-value..) A second layer may contain the support structure of the MRI RF coils, which are located around the phantom 108. An outer mechanical layer may provide mechanical protection and robustness and is equipped with mechanical fixation points, markers, and holders as an interface to the MRI system environment. MRI system environment may comprise the patient bed 106, support, dedicated mechanical support holders etc.. An electronic interface may be located on one of the layers, which controls the sensors and the locally distributed MRI coils. The interface of the phantom is wireless or uses optical or galvanic connection to the MRI system to exchange real time data of the sensors, status information, control signals and configuration settings.

In another example, distributed local sensors 302 are wireless and communicate to the local interface 306. Sensors 302 may use energy harvesting for power supply or energy from local interface of quantitative MRI phantom.

In another example, there are dedicated sensors to detect air bubbles of the local phantom. This may provide a quality check realized to measure the amount of air bubbles in the local phantom compartments. Here the sensor is realized as conductive, US or optical sensor. The total volume of the phantom liquid is determined and checked versus defined quality parameters for the phantom. If a threshold is surpassed, the Magnetic resonance imaging system does not allow scanning with the phantom.

In another example, there may be an identification of the phantom via RF identification or via the electronic interface 306.

In another example, the quantitative MRI phantom communicates with an app (that for example runs on a smartphone). Before the user starts a pulse sequence, the app tells the user (via WLAN) about the status of the phantom: temperature, compartments filled, last service and certificate, last time used, position in the hospital, phantom ready, defect, liquid lossand possibly the need for preparation and planning of an MRI scan. One advantage of having the information available from an app is that the MR operator may see not just the status of the phantoms in a particular MRI examination room but may have an overview of the status of phantoms available at a particular location, i.e. hospital. The operator may be able to make more efficient use of the phantoms and possibly select phantoms which have a better or more recent status (select the phantom which was serviced most recently).

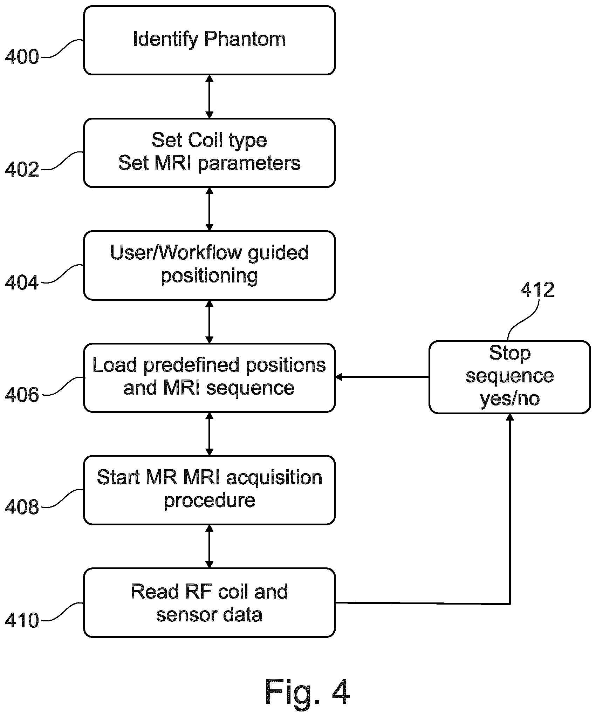

Fig. 4 shows a flowchart which illustrates one method of operating the medical system 300 of Fig. 3. In 400 the phantom is identified. This may for example be done using a QR code or RF identification. The magnetic resonance imaging system 114 may for example do a safety check and quality status of the phantom 108. For example it may ensure that the phantom is not expired. In 402 the coil type and MRI parameters for a particular calibration are set. In 404, the phantom may be positioned either manually or with the actuator 104. In 406 a predefined positions and MRI sequence 406 are loaded. This may for example be in the form of pulse sequence commands. In 408 the MRI acquisition is started and in 410 the k-space data is read using the surface coils 304. In 412 it is determined if the sequence should stop or not. For example, when the phantom detects a failure (low MRI signal, acceptable quality of phantom, B1 inhomogeneity ...), the scan may be stopped, or the operator receives a warning. If the calibration is finished then the sequence stops here and if not, a new position may be loaded in 406 and the process is repeated at different locations until the full calibration is complete.

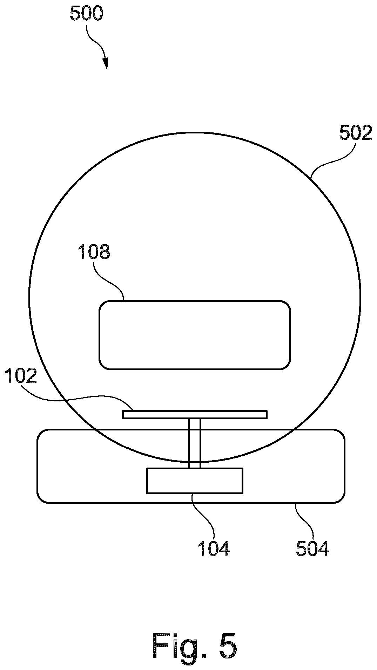

Fig. 5 illustrates a further example of a medical system 500. In this example the phantom mount 102 and the automated actuator 104 are integrated into a magnetic resonance imaging coil. There is a coil interface 504 which contains the automated actuator 104 and is connected to the phantom mount 102. There is a radio-frequency coil array 502 for the magnetic resonance imaging coil and the quantitative MRI phantom 108 is placed within the imaging area of the Magnetic resonance imaging coil 502.

As shown in Fig. 5 there is an MRI coil 502 with integrated phantom mount 102 and an integrated, automated actuator 104.

The setup 500 allows to place the quantitative MRI phantom 108 directly in the coil 502 without any further additional mechanics to be mounted. The coil housing may have an integrated actuator 104, which can be activated when the coil 502 is empty. In one example, as shown in the Fig. 5, the positioning system (automated actuator 104) is integrated in the bottom of the coil. The phantom mount 102 holds the phantom and different positions can be addressed by rotation, translation and angulation of the phantom mount 102.

Different mechanical structures for the automated actuator 104 can be realized as suspension of the support of the phantom holder or external fixation and slide structures located at the circumference of the coil. The electronic drive and the sensors may be controlled via a common coil interface. Integrated sensors may switch between modes, control the distance and predefined positions and patient safety. If a patient is in the medical system 500, then system may be deactivated. Different modes of the medical system 500 can be defined as: MRI imaging mode, quantitative MRI Phantom mode, Calibration mode, Patient positioning, Phantom placement.

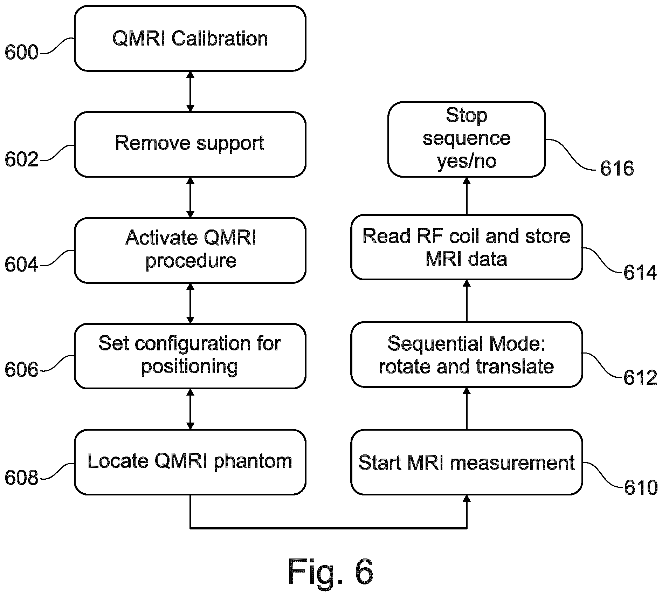

Fig. 6 shows a flowchart which illustrates a method of operating the medical system 500 of Fig. 5. The features of Figs. 1, 3, and 5 can be combined. In 600 the quantitative magnetic resonance imaging calibration for the coil is activated in the quantitative magnetic resonance imaging mode. Here the system asks the user to place the coil and remove gadgets such as dedicated patient supports. The support is removed in 602. In 604 the quantitative magnetic resonance imaging procedures are activated. In 606 the configuration for the positioning of the quantitative magnetic resonance imaging phantom 108 is set or begun. In 608 the location of the quantitative MRI phantom 108 is set. In 610 the magnetic resonance imaging for the calibration is performed. 612 represents performing the measurement more than once and represents a sequential mode where the sample is rotated and/or translated and the magnetic resonance imaging measurement 610 is repeated again. In 614 the RF coil is read and the magnetic resonance imaging or k-space data is stored. In 616 it is determined whether the system has finished the calibration or if another position should be measured. If another position should be measured then the method repeats back to 606.

There may be several different procedures related to quality assurance/control and calibration. For quality assurance/quality control one could check if the calibration measurements made on the phantom 108 are within specs once in the beginning and then check in regular time intervals if the values are consistent. The temporal stability does not need to include the complete scan at different positions done in the beginning but needs to be reproducible. Then there is the calibration procedure for which a phantom with known properties could be scanned with every patient and one can correct the in vivo quantitative MRI values according to the phantom measurements.

The MR calibration measurement is started, when the coil is at the isocenter, and operator has left the MRI room. During the measurement, clinical safety is provided by sensors located at the coil to prevent accidental interaction with the operator. During the sequential mode different predefined positions are addressed. The data is stored and used and prepared as dataset to calibrate the clinical MR imaging sequences. A calibration is done to adjust the in vivo values based on a simultaneously scanned phantom.

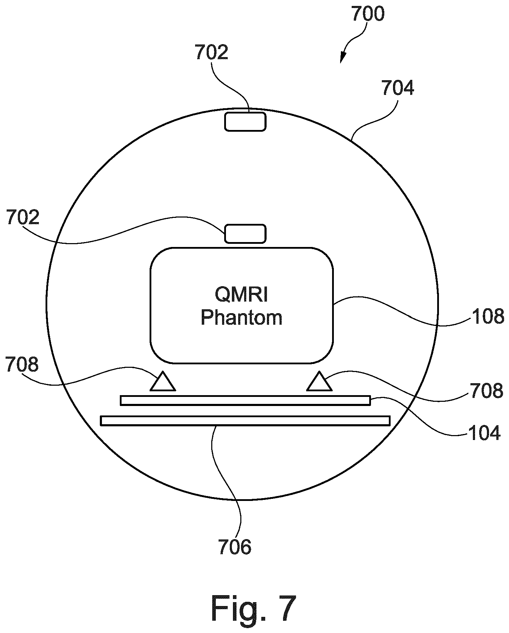

Fig. 7 illustrates a further example of the medical system 700. Within the bore of a magnet 704 the quantitative magnetic resonance imaging phantom 108 is sitting on a vibration cancellation system 708. This may be positioned on the automated actuator 104 and ultimately the subject support 706. There are two sensors 702 which may for example be a set of optical sensors or a microwave sensor which is used to measure the vibration or motion of the phantom 108. In response, the vibration cancellation system 708 is able to move and cancel vibrations in the quantitative MRI phantom 108. As the quantitative MRI calibration samples 110 are typically liquid they may be sloshed around or cause fluid flow due to the vibrations caused by the gradient coils. The vibration cancellation system 708 is used to cancel these vibrations and improve the quality of the calibration.

Vibration compensation may be used to reduce or eliminate vibration noise. There are two kinds of vibration compensation: the first one is post-correction, and the second one is real time compensation. Vibrations from the gradient system are unavoidable, as such constructions are particularly sensitive to many of the regular work processes. It is inevitable that disruptive vibrations will occur and disturb and have a negative and uncontrollable influence on the characterization of a quantitative MRI calibration.

Bulk and micro-vibration may seriously affects the performance of quantitative MRI calibrations. To suppress or compensate the micro-vibration effectively, it is necessary to measure it accurately. To reduce the effect of forced vibrations exciting a structure out of resonance, the most promising approach is to generate a counteracting force on the quantitative MRI phantom 108 and an active system with the force being controlled by adaptive feed forward control is proposed.

Difficulties overcome by the medical system 700 illustrated in fig 7 may include one or more of the following:
- reduce the impact of Structural Vibration on phantom (table, mechanical modes)
- provide for a higher quality phantom 108 to characterize MRI systems
- reduce flow by uncontrolled vibration
- reduce mechanical vibrations of phantoms 108
- reduce bias or artifacts
- reduce or eliminate poor reproducibility due to mechanical vibration
- provide better vibration mitigation than passive systems
- reduce SNR and resolution disturbed by mechanical vibration and resonance

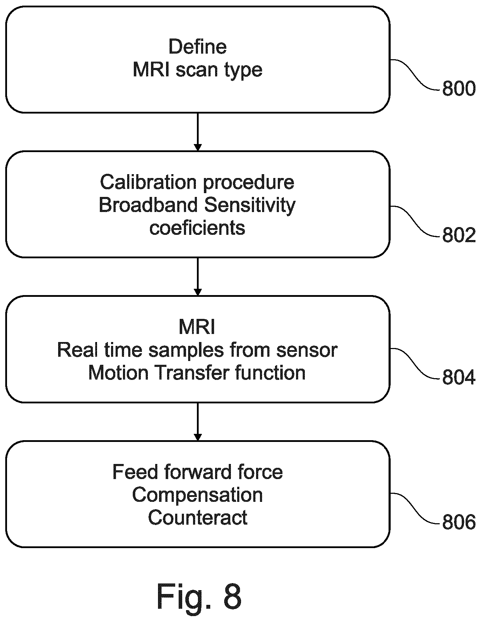

Fig. 8 shows a flowchart of a method of using the vibration cancellation system 708 to cancel vibrations of the quantitative MRI phantom 108. In 800 the type of magnetic resonance imaging scan is defined. In 802 during the calibration procedure broadband sensitivity coefficients are prepared. In 804 during a magnetic resonance imaging sampling the real time samples from the sensor motion are input into a motion transfer function and used to control the vibration cancellation system 708. In 806 there is a feed forward force provided by the vibration cancellation system 708 and is used to provide compensation and to counteract the vibrations.

As shown in Fig.1 a magnetic resonance imaging (MRI) system with an active vibration control of a quantitative MRI phantom is provided. A few piezo electric actuators are positioned between the phantom 108 or support structure and the patient bed or an interleaved adaptation device. A control unit supplies the actuators to control the displacements and to reduce the mechanical movements of the MRI phantom. The compensation force may be applied in a feed forward fashion based on a predetermined electrical signal-to-gradient assembly motion transfer function.

The transfer function is obtained by measuring directly the motion of the phantom/ support of phantom using sensors like a camera-based approach, or using local sensors (acceleration) located at the phantom or the support structure when a gradient signal is applied. The correct force to the actuators is calculated using a local/remote processor by training a neuronal network. The trained network applies the correct data to the controller of the actuator. In some examples, there may be a transfer function that is directly derived from the MRI data in k- space or image space to measure the error function for compensation.

Ways of detecting motion of the quantitative MRI phantom and of compensating for motion may include the use of one or more of the following:
- use sensors to measure the motion may be directly located on the phantom and wirelessly transmit the vibration data to an FPGA unit.
- Alternatively, the error signal is generated from the MRI motion signals of the phantom
- Optical signals are applied from camera-based system, which observes the phantom or related markers on the phantom
- A FMCW RADAR system is in the bore is used for detection of the motion signal
- An eddy current based approach may be applied to locate sensors on the phantom and measure the induced complex EMF signal.

The predetermined vibration sensitivity coefficients for a model may be determined via comparison of measurements unaffected by vibration to those obtained from the sensor data affected by vibration in real time. As shown in Fig. 8 the method reduces the effect from vibration by using a calibration procedure, where frequency broadband error coefficients are obtained. These coefficients may be obtained by individually selecting the gradients axis using sensors located at different positions on the gradient support and from the sensors (mechanical, optical, electrical/radar) of the phantom.

Alternatively, the data is applied to train a neuronal network. The network is trained for different MRI scans, phantoms and type of sensors. The sensors may be different and depend on position or location of the phantom (located in/off the coil).

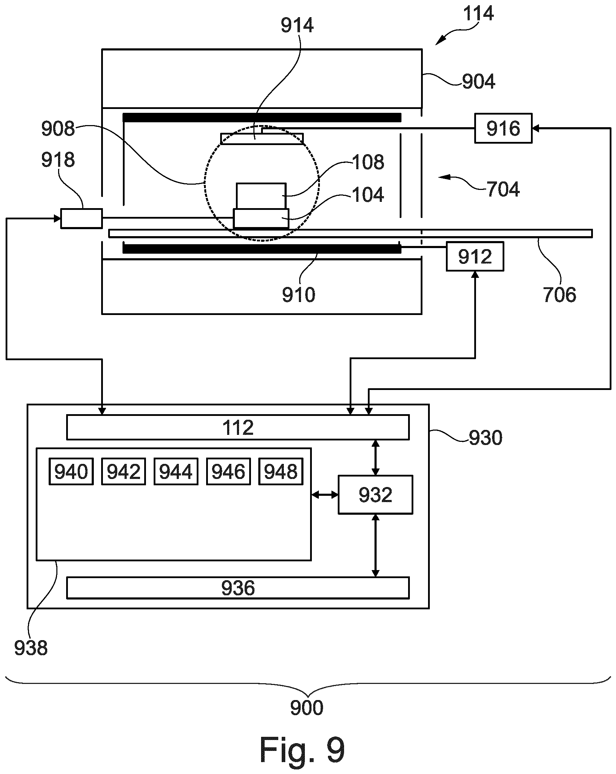

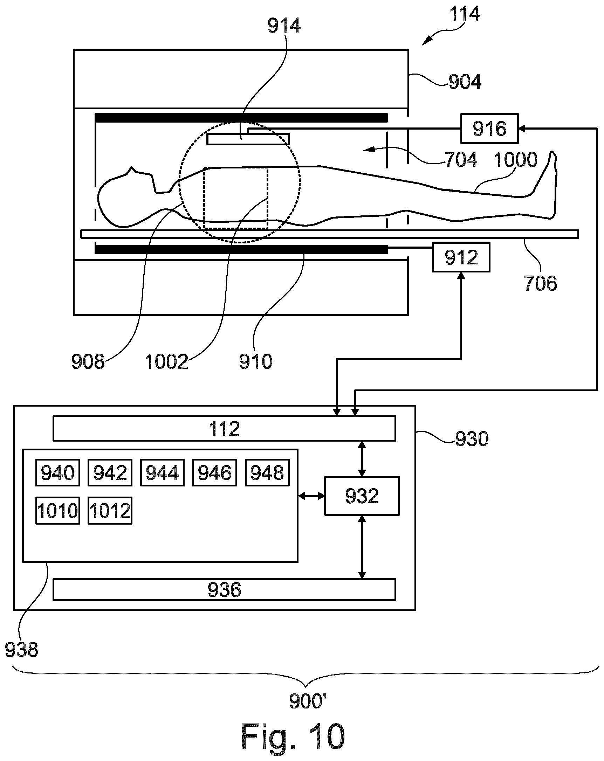

Figs. 9 and 10 illustrate a further example of a medical system 900. In Fig. 9 the medical system 900 detects the system during a calibration phase. In Fig. 10 the medical system 900' is shown imaging a subject. The medical system 900 comprises a magnetic resonance imaging system 114 and a computer 930 or local controller. The magnetic resonance imaging system 114 comprises a magnet 904. The magnet 904 is a superconducting cylindrical type of magnet with a bore 704 through it. It is also possible to use both a split cylindrical magnet and a so-called open magnet. A split cylindrical magnet is similar to a standard cylindrical magnet, except that the cryostat has been split into two sections to allow access to the iso-plane of the magnet. Such magnets may for instance be used in conjunction with charged particle beam therapy. An open magnet has two magnet sections, one above the other with a space in-between that is large enough to receive a subject. The arrangement of the two magnet sections is similar to that of a Helmholtz coil. Open magnets are popular because the subject is less confined. Inside the cryostat of the cylindrical magnet there is a collection of superconducting coils.

Within the bore 704 of the cylindrical magnet 904 there is an imaging zone 908 where the magnetic field is strong and uniform enough to perform magnetic resonance imaging. A field of view 109 is shown in Fig. 10 within the imaging zone 1002. The k-space data are acquired for the field of view 1002.

Within the bore 704 of the magnet there is also a set of magnetic field gradient coils 910 which is used for the acquisition of k-space data to spatially encode magnetic spins within the imaging zone 908 of the magnet 904. The magnetic field gradient coils 910 are connected to a magnetic field gradient coil power supply 912. The magnetic field gradient coils 910 are intended to be representative. Typically, magnetic field gradient coils 910 contain three separate sets of coils for spatial encoding in three orthogonal spatial directions. A magnetic field gradient power supply supplies current to the magnetic field gradient coils. The current supplied to the magnetic field gradient coils 910 is controlled as a function of time and may be ramped or pulsed.

Adjacent to the imaging zone 908 is a radio frequency coil 914 for manipulating the orientations of magnetic spins within the imaging zone 908 and for receiving radio transmissions from spins also within the imaging zone 908. The radio frequency antenna may contain multiple coil elements. The radio frequency antenna may also be referred to as a channel or antenna. The radio frequency coil 914 is connected to a radio frequency transceiver 916. The radio frequency coil 914 and radio frequency transceiver 916 may be replaced by separate transmit and receive coils and a separate transmitter and receiver. It is understood that the radio frequency coil 914 and the radio frequency transceiver 916 are representative. The radio frequency coil 914 is intended to also represent a dedicated transmit antenna and a dedicated receive antenna. Likewise, the transceiver 916 may also represent a separate transmitter and receiver. The radio frequency coil 914 may also have multiple receive/transmit elements and the radio frequency transceiver 916 may have multiple receive/transmit channels.

Within the imaging zone 908 the quantitative MRI phantom 108 is shown as resting on the automated actuator 104. There is a mechanical drive 918 located out of the bore 704 of the magnet 904. For example the mechanical drive 918 could provide compressed air which is used to controllably manipulate and move the automated actuator 104. The automated actuator 104 is able to move the quantitative MRI phantom 108 into different locations during the calibration process.

The memory 938 is shown as containing machine-executable instructions. The machine-executable instructions 940 may for example provide such things as an operating system, as well as commands which enable the computational system 932 to control the operation and function of the various components of the medical system 900, 900'. The machine-executable instructions 940 may also enable the computational system 932 to provide basic computational and image processing tasks. The memory 938 is further shown as containing quantitative MRI calibration pulse sequence commands 942. In some examples these may also contain movement commands which are used to control the mechanical drive 918. The memory 938 is further shown as containing calibration k-space data 944 that was acquired by controlling the magnetic resonance imaging system 114 with the quantitative MRI calibration pulse sequence commands 942. The memory 938 is further shown as containing a spatially dependent quantitative MRI calibration 946 that was determined or generated using the calibration k-space data 944. The memory 938 may also contain quantitative MRI pulse sequence commands 948 that are able to acquire k-space data that uses the spatially dependent quantitative MRI calibration 946 during the reconstruction.

In Fig. 10 the quantitative MRI phantom 108 and the automated actuator 104 have been removed and instead a subject 1000 is resting on the subject support 706. The memory 938 is further shown as containing subject k-space data 1010 that has been acquired from the field of view 1002 by controlling the magnetic resonance imaging system 114 with the quantitative MRI pulse sequence commands 948. The memory 938 is further shown as containing a quantitative magnetic resonance image 1012 that has been reconstructed from the subject k-space data 1010 and using the spatially dependent quantitative MRI calibration 946.

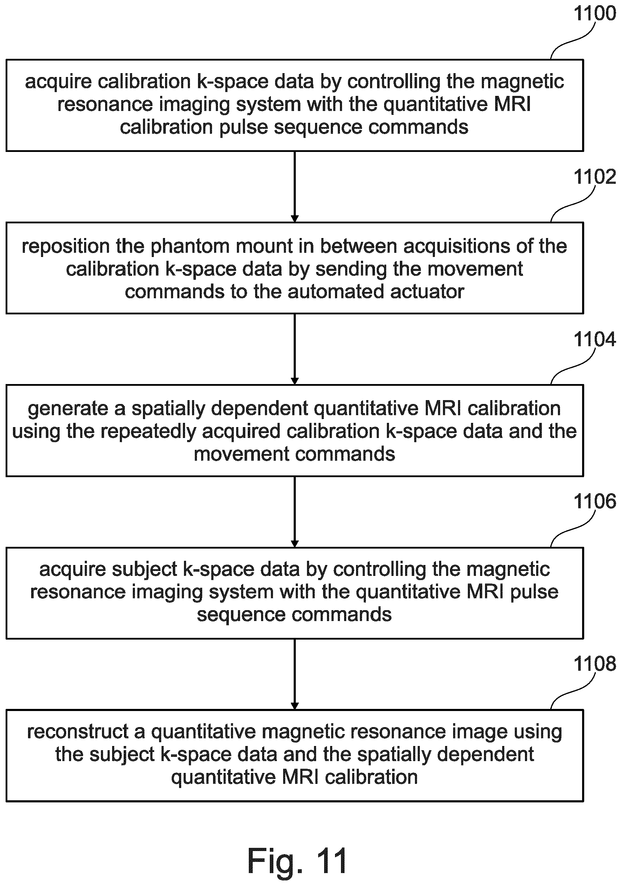

Fig. 11 shows a flowchart which illustrates a method of using the medical system 900, 900' illustrated in Figs. 9 and 10. In 1100 the calibration k-space data 944 is acquired by controlling the magnetic resonance imaging system 114 with the quantitative MRI calibration pulse sequence commands 942. In 1102 the phantom mount 102 is repositioned in between acquisitions of the calibration k-space data 944 by sending the movement commands to the automated actuator 104. In 1104 the spatially dependent quantitative MRI calibration 946 is generated using the repeatedly acquired calibration k-space data 944 and a knowledge of the movement commands. In 1106 the subject k-space data 1010 is acquired by controlling the magnetic resonance imaging system with the quantitative MRI pulse sequence commands 948. In 1108 the quantitative magnetic resonance image 1012 is reconstructed using the subject k-space data 1010 and the spatially dependent quantitative MRI calibration 946.

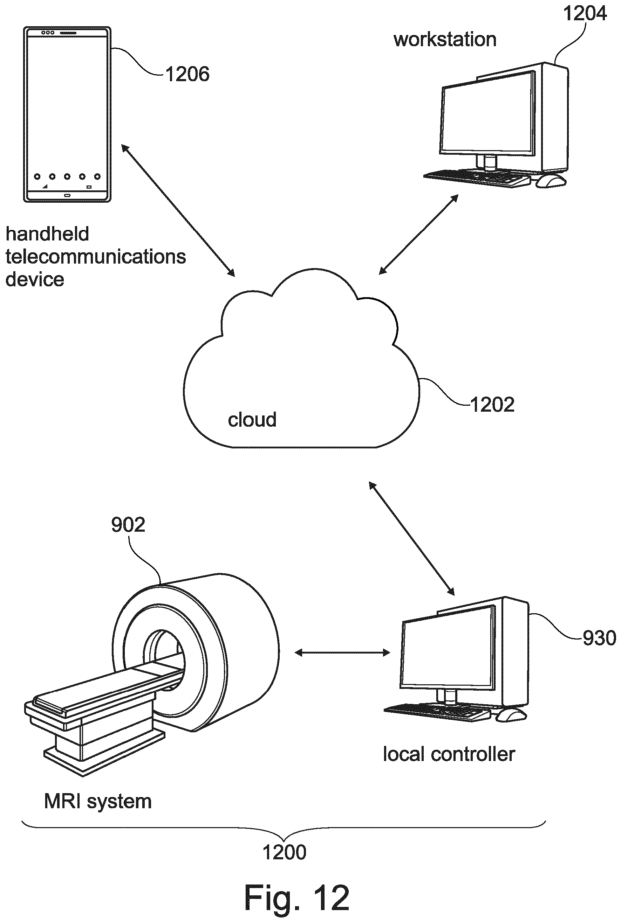

Fig. 12 illustrates a further example of a medical system 1200 where the reconstruction is performed in a cloud-based system 1202. The medical system 1200 comprises the MRI system 902 and a local controller 930. In many examples the local controller 930 may be the computer as illustrated in Figs. 9 and 10. The local controller 930 may send the calibration k-space data 944 and/or the subject k-space data 1010 to the cloud system 1202. The cloud system may for example be a remote server or may be a virtual or real blades and computational systems. Once the cloud-based system 1202 has received the spatially dependent quantitative MRI calibration 946 and/or the quantitative magnetic resonance image 1012 it may share it with other devices that are connected to it. For example, the resulting quantitative magnetic resonance image 1012 may be sent back to the local controller 930. In other examples the quantitative magnetic resonance image 1012 could be shared with a handheld telecommunications device 1206 such as a smartphone or sent to another computer or workstation 1204. The workstation 1204 could for example be a workstation in a radiology department or other medical facility.

It is understood that one or more of the aforementioned examples or embodiments of the invention may be combined as long as the combined embodiments are not mutually exclusive.

As will be appreciated by one skilled in the art, aspects of the present invention may be embodied as an apparatus, method or computer program product. Accordingly, aspects of the present invention may take the form of an entirely hardware embodiment, an entirely software embodiment (including firmware, resident software, micro-code, etc.) or an embodiment combining software and hardware aspects that may all generally be referred to herein as a "circuit", "module" or "system." Furthermore, aspects of the present invention may take the form of a computer program product embodied in one or more computer readable medium(s) having computer executable code embodied thereon.

Any combination of one or more computer readable medium(s) may be utilized. The computer readable medium may be a computer readable signal medium or a computer readable storage medium. A 'computer-readable storage medium' as used herein encompasses any tangible storage medium which may store instructions which are executable by a processor or computational system of a computing device. The computer-readable storage medium may be referred to as a computer-readable non-transitory storage medium. The computer-readable storage medium may also be referred to as a tangible computer readable medium. In some embodiments, a computer-readable storage medium may also be able to store data which is able to be accessed by the computational system of the computing device. Examples of computer-readable storage media include, but are not limited to: a floppy disk, a magnetic hard disk drive, a solid state hard disk, flash memory, a USB thumb drive, Random Access Memory (RAM), Read Only Memory (ROM), an optical disk, a magneto-optical disk, and the register file of the computational system. Examples of optical disks include Compact Disks (CD) and Digital Versatile Disks (DVD), for example CD-ROM, CD-RW, CD-R, DVD-ROM, DVD-RW, or DVD-R disks. The term computer readable-storage medium also refers to various types of recording media capable of being accessed by the computer device via a network or communication link. For example, data may be retrieved over a modem, over the internet, or over a local area network. Computer executable code embodied on a computer readable medium may be transmitted using any appropriate medium, including but not limited to wireless, wire line, optical fiber cable, RF, etc., or any suitable combination of the foregoing.

A computer readable signal medium may include a propagated data signal with computer executable code embodied therein, for example, in baseband or as part of a carrier wave. Such a propagated signal may take any of a variety of forms, including, but not limited to, electro-magnetic, optical, or any suitable combination thereof. A computer readable signal medium may be any computer readable medium that is not a computer readable storage medium and that can communicate, propagate, or transport a program for use by or in connection with an instruction execution system, apparatus, or device.

'Computer memory' or 'memory' is an example of a computer-readable storage medium. Computer memory is any memory which is directly accessible to a computational system. 'Computer storage' or 'storage' is a further example of a computer-readable storage medium. Computer storage is any non-volatile computer-readable storage medium. In some embodiments computer storage may also be computer memory or vice versa.

A 'computational system' as used herein encompasses an electronic component which is able to execute a program or machine executable instruction or computer executable code. References to the computational system comprising the example of "a computational system" should be interpreted as possibly containing more than one computational system or processing core. The computational system may for instance be a multi-core processor. A computational system may also refer to a collection of computational systems within a single computer system or distributed amongst multiple computer systems. The term computational system should also be interpreted to possibly refer to a collection or network of computing devices each comprising a processor or computational systems. The machine executable code or instructions may be executed by multiple computational systems or processors that may be within the same computing device or which may even be distributed across multiple computing devices.

Machine executable instructions or computer executable code may comprise instructions or a program which causes a processor or other computational systems to perform an aspect of the present invention. Computer executable code for carrying out operations for aspects of the present invention may be written in any combination of one or more programming languages, including an object-oriented programming language such as Java, Smalltalk, C++ or the like and conventional procedural programming languages, such as the C programming language or similar programming languages and compiled into machine executable instructions. In some instances, the computer executable code may be in the form of a high-level language or in a pre-compiled form and be used in conjunction with an interpreter which generates the machine executable instructions on the fly. In other instances, the machine executable instructions or computer executable code may be in the form of programming for programmable logic gate arrays.

The computer executable code may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a Local Area Network (LAN) or a Wide Area Network (WAN), or the connection may be made to an external computer (for example, through the Internet using an Internet Service Provider).

Aspects of the present invention are described with reference to flowchart illustrations and/or block diagrams of methods, apparatus (systems) and computer program products according to embodiments of the invention. It is understood that each block or a portion of the blocks of the flowchart, illustrations, and/or block diagrams, can be implemented by computer program instructions in form of computer executable code when applicable. It is further understood that, when not mutually exclusive, combinations of blocks in different flowcharts, illustrations, and/or block diagrams may be combined. These computer program instructions may be provided to a computational system of a general-purpose computer, special-purpose computer, or other programmable data processing apparatus to produce a machine, such that the instructions, which execute via the computational system of the computer or other programmable data processing apparatus, create means for implementing the functions/acts specified in the flowchart and/or block diagram block or blocks.

These machine executable instructions or computer program instructions may also be stored in a computer readable medium that can direct a computer, other programmable data processing apparatus, or other devices to function in a particular manner, such that the instructions stored in the computer readable medium produce an article of manufacture including instructions which implement the function/act specified in the flowchart and/or block diagram block or blocks.

The machine executable instructions or computer program instructions may also be loaded onto a computer, other programmable data processing apparatus, or other devices to cause a series of operational steps to be performed on the computer, other programmable apparatus or other devices to produce a computer implemented process such that the instructions which execute on the computer or other programmable apparatus provide processes for implementing the functions/acts specified in the flowchart and/or block diagram block or blocks.

A 'user interface' as used herein is an interface which allows a user or operator to interact with a computer or computer system. A 'user interface' may also be referred to as a 'human interface device.' A user interface may provide information or data to the operator and/or receive information or data from the operator. A user interface may enable input from an operator to be received by the computer and may provide output to the user from the computer. In other words, the user interface may allow an operator to control or manipulate a computer and the interface may allow the computer to indicate the effects of the operator's control or manipulation. The display of data or information on a display or a graphical user interface is an example of providing information to an operator. The receiving of data through a keyboard, mouse, trackball, touchpad, pointing stick, graphics tablet, joystick, gamepad, webcam, headset, pedals, wired glove, remote control, and accelerometer are all examples of user interface components which enable the receiving of information or data from an operator.

A 'hardware interface' as used herein encompasses an interface which enables the computational system of a computer system to interact with and/or control an external computing device and/or apparatus. A hardware interface may allow a computational system to send control signals or instructions to an external computing device and/or apparatus. A hardware interface may also enable a computational system to exchange data with an external computing device and/or apparatus. Examples of a hardware interface include but are not limited to: a universal serial bus, IEEE 1394 port, parallel port, IEEE 1284 port, serial port, RS-232 port, IEEE-488 port, Bluetooth connection, WLAN connection, TCP/IP connection, Ethernet connection, control voltage interface, MIDI interface, analog input interface, and digital input interface.

A 'display' or 'display device' as used herein encompasses an output device or a user interface adapted for displaying images or data. A display may output visual, audio, and or tactile data. Examples of a display include, but are not limited to: a computer monitor, television screen, touch screen, tactile electronic display, Braille screen, Cathode Ray Tube (CRT), storage tube, bi-stable display, electronic paper, vector display, flat panel display, Vacuum Fluorescent (VD) display, Light-Emitting Diode (LED) displays, Electro-Luminescent Display (ELD), Plasma Display Panels (PDP), Liquid Crystal Display (LCD), Organic Light-Emitting Diode (OLED) displays, a projector, and head-mounted display.

While the invention has been illustrated and described in detail in the drawings and foregoing description, such illustration and description are to be considered illustrative or exemplary and not restrictive; the invention is not limited to the disclosed embodiments.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. A single processor or other unit may fulfill the functions of several items recited in the claims. The mere fact that certain measures are recited in mutually different dependent claims does not indicate that a combination of these measures cannot be used to advantage. A computer program may be stored/distributed on a suitable medium, such as an optical storage medium or a solid-state medium supplied together with or as part of other hardware, but may also be distributed in other forms, such as via the Internet or other wired or wireless telecommunication systems. Any reference signs in the claims should not be construed as limiting the scope.

### REFERENCE SIGNS LIST

- 100: medical system
- 102: phantom mount
- 104: automated actuator
- 106: support for phantom mount
- 108: quantitative MRI phantom
- **110**: quantitative MRI calibration sample
- 112: optional control interface
- **114**: optional MRI system
- 116: optional remote control
- 200: detection of setup
- 202: adapt automated actuator and quantitative MRI phantom
- 204: configure setup
- 206: start measurement
- 208: quality assessment procedure
- 210: stop measurement
- 300: medical system
- 302: sample specific sensors
- 304: surface coil
- 306: data transmission system
- 308: optional database
- 400: identify phantom
- 402: set coil type and set MRI parameters
- 404: user/workflow guided positioning
- 406: load predefined positions and MRI sequence
- 408: start MR MRI acquisition procedure
- 410: read RF coil and sensor data
- 412: stop sequence yes/no
- 500: medical system
- 502: Magnetic resonance imaging coil
- 504: coil interface
- 600: quantitative MRI calibration
- 602: remove support
- 604: activate quantitative MRI procedure
- 606: set configuration for positioning
- 608: locate quantitative MRI phantom
- 610: start MRI measurement
- 612: sequential mode: rotate and translate
- 614: read RF coil and store MRI data
- 616: stop sequence yes/no
- 700: medical system
- 702: motion sensors
- 704: bore of magnet
- 706: subject support
- 708: vibration cancellation system
- 800: define MRI scan type
- 802: calibration procedure, determine broad band sensitivity coefficients
- 804: MRI, acquire real time samples from sensor motion transfer function
- 806: feed forward force compensation to counteract vibrations
- 900: medical system (during calibration)
- 900': medical system (during clinical imaging)
- 904: magnet
- 908: imaging zone
- 910: magnetic field gradient coils
- 912: magnetic field gradient coil power supply
- 914: radio frequency coil
- 916: transceiver
- 918: mechanical drive
- 930: computer
- 932: computational system
- 936: optional user interface
- 938: memory
- 940: machine executable instructions
- 942: quantitative MRI calibration pulse sequence commands
- 944: calibration k-space data
- 946: spatially dependent quantitative MRI calibration
- 948: quantitative MRI pulse sequence commands
- 1000: subject
- 1002: field of view
- 1010: subject k-space data
- 1012: quantitative magnetic resonance image
- 1100: acquire calibration k-space data by controlling the magnetic resonance imaging system with the quantitative MRI calibration pulse sequence commands
- 1102: reposition the phantom mount in between acquisitions of the calibration k-space data by sending the movement commands to the automated actuator
- 1104: generate a spatially dependent quantitative MRI calibration using the repeatedly acquired calibration k-space data and the movement commands
- 1106: acquire subject k-space data by controlling the magnetic resonance imaging system with the quantitative MRI pulse sequence commands
- 1108: reconstruct a quantitative magnetic resonance image using the subject k-space data and the spatially dependent quantitative MRI calibration
- 1200: medical system
- 1202: cloud computing system
- 1204: workstation
- 1206: handheld telecommunications device

## Claims

1. A medical system (100, 300, 500, 700, 900, 900') comprising a phantom positioning system, wherein the phantom positioning system comprises:
- a phantom mount (102) configured for receiving a quantitative MRI phantom (108),
- an automated actuator (104) configured to reposition the phantom mount in response to receiving movement commands, wherein the movement commands are preferably embedded in quantitative MRI calibration pulse sequence commands (948).

2. The medical system of claim 1, wherein the automated actuator is configured to position the phantom mount with respect to coordinates within a bore (704) of a magnetic resonance imaging magnet (904).

3. The medical system of claim 1 or 2, wherein the medical system further comprises the quantitative MRI phantom attached to the phantom mount, and wherein the quantitative MRI phantom comprises at least one quantitative MRI calibration sample (110), and wherein the automated actuator is configured to move the at least one quantitative MRI calibration sample to multiple locations in response to receiving the movement commands.

4. The medical system of claim 3, wherein the quantitative MRI phantom comprises at least one sample specific sensor (302) configured for measuring sample specific data, wherein the quantitative MRI phantom comprises a data transmission system for transmitting the sample specific data, wherein the sample specific data preferably comprises any one of the following: a sample temperature, a sample conductivity, a sample pH-value, and combinations thereof, and wherein the data transmission system is preferably a radio frequency communication system or preferably a fiber optic communication system.

5. The medical system of claim 3 or 4, wherein the quantitative MRI phantom comprises an identification element configured to provide any one of the following: an identification of a quantitative MRI phantom type, and expiration date of the quantitative MRI phantom, a serial number linked to data descriptive of the quantitative MRI phantom, and combinations thereof.

6. The medical system of claim 3, 4, or 5, wherein the quantitative MRI phantom further comprises radio-frequency coils (304) for measuring k-space data descriptive of the at least one quantitative MRI calibration sample, wherein the radio-frequency coils are preferably surface coils attached to an external surface of the quantitative MRI phantom, wherein the quantitative MRI phantom comprises a data transmission system (306) for transmitting the k-space data, and wherein the wherein the data transmission system is preferably a radio frequency communication system or preferably a fiber optic communication system.

7. The medical system of any one of the preceding claims, wherein the phantom positioning system is integrated into a magnetic resonance imaging coil 502, wherein the wherein the magnetic resonance imaging coil is preferably a head coil or a breast coil.

8. The medical system of any one of claims 1 through 5, wherein the phantom positioning system is integrated into a magnetic resonance imaging subject support (106, 706).

9. The medical system of any one of the preceding claims, wherein the medical system further comprises a vibration cancellation system (708), wherein the vibration cancellation system comprises a piezoelectric actuator configured for moving the phantom mount to counter act vibrations of the quantitative MRI phantom.

10. The medical system of claim 9, wherein the piezoelectric actuator is at least partially configured to be controlled to counteract the vibrations of the quantitative MRI phantom determined using any one of the following: an acoustic sensor, an optical motion sensor, a microwave sensor, and combinations thereof.

11. The medical system of claim 9 or 10, wherein the piezoelectric actuator is at least partially configured to be controlled to counteract the vibrations of the quantitative MRI phantom determined by a transfer function that receives gradient coils commands as input, the gradient coil commands being specified in the MRI calibration pulse sequence commands.

12. The medical system of any one of the preceding claims, wherein the medical system further comprises a magnetic resonance imaging system (114), wherein the magnetic resonance imaging system comprises:
- a memory (938) storing machine executable instructions (940) and the quantitative MRI calibration pulse sequence commands (942); and
- a computational system (932), wherein execution of the machine executable instructions causes the computational system to repeatedly:
- acquire (1100) calibration k-space data (944) by controlling the magnetic resonance imaging system with the quantitative MRI calibration pulse sequence commands;
- reposition (1102) the phantom mount in between acquisitions of the calibration k-space data by sending the movement commands to the automated actuator; and
- generate (1104) a spatially dependent quantitative MRI calibration (946) using the repeatedly acquired calibration k-space data and the movement commands.

13. The medical system of claim 12, where the quantitative MRI calibration pulse sequence commands are configured according to a predetermined quantitative MRI protocol, wherein the memory further stores quantitative MRI pulse sequence commands (948) configured to acquire subject k-space data according to the predetermined quantitative MRI protocol, wherein execution of the machine executable instructions further causes the computational system to:
- acquire (1106) subject k-space data (1010) by controlling the magnetic resonance imaging system with the quantitative MRI pulse sequence commands (948); and
- reconstruct (1108) a quantitative magnetic resonance image (1012) using the subject k-space data and the spatially dependent quantitative MRI calibration.

14. A method of operating the medical system (900, 900') of claim 12 or 13, wherein the method comprises:
- acquiring (1100) calibration k-space data (944) by controlling the magnetic resonance imaging system (114) with the quantitative MRI calibration pulse sequence commands (942);
- repositioning (1102) the phantom mount in between acquisitions of the calibration k-space data by sending the movement commands to the automated actuator; and
- generating (1104) a spatially dependent quantitative MRI calibration (946) using the repeatedly acquired calibration k-space data and the movement commands

15. A computer program product comprising a computer-readable storage medium (938) having machine executable instructions (940) embodied therewith, said machine executable instructions configured to implement the method of claim 14.
